Europäisches Patentamt

European Patent Office

Office européen des brevets

(11) Veröffentlichungsnummer: **0 249 026**
**A2**

(12) **EUROPÄISCHE PATENTANMELDUNG**

(21) Anmeldenummer: **87106544.7**

(22) Anmeldetag: **06.05.87**

(51) Int. Cl.³: **H 03 M 1/30**

(30) Priorität: **09.06.86 DE 3619408**

(43) Veröffentlichungstag der Anmeldung:
**16.12.87 Patentblatt 87/51**

(84) Benannte Vertragsstaaten:
**AT BE CH DE ES FR GB GR IT LI LU NL SE**

(71) Anmelder: **Battelle-Institut e.V.**
**Am Römerhof 35 Postfach 900 160**
**D-6000 Frankfurt/Main 90(DE)**

(72) Erfinder: **Gerrath, Karl-Heinz, Dr.**
**Lindenstrasse 2**
**D-6103 Griesheim(DE)**

(72) Erfinder: **Strauss, Eberhard, Dr.**
**Lindenstrasse 32**
**D-6103 Griesheim(DE)**

(72) Erfinder: **Decker, Hans-Joachim**
**Breitenbachstrasse 63**
**D-6200 Wiesbaden(DE)**

(72) Erfinder: **Vinson, Heinz**
**Wallstrasse 15**
**D-6070 Langen(DE)**

(54) Anordnung zur Gewinnung von geradsymmetrischen Signalen.

(57) In einer Anordnung zur Gewinnung von geradsymmetrischen Signalen aus mindestens zwei Signalgebern mit periodischer Struktur, die relativ zueinander beweglich sind, mit Sensoren, die der Position der Signalgeber entsprechende Signale generieren, werden für mindestens einen Signalgeber mindestens zwei Sensoren vorgesehen. Die Signale der Sensoren sind in einer Subtrahier- oder Addierstufe miteinander verknüpfbar. Die Sensoren werden eine halbe Periode der Struktur des Signalgebers oder einem ganzzahligen Vielfachen hiervon versetzt zueinander angeordnet.

Fig. 3

0249026

## Beschreibung

Die Erfindung betrifft eine Anordnung zur Gewinnung von geradsymmetrischen Signalen aus mindestens zwei Signalgebern mit periodischer Struktur, die relativ zueinander beweglich sind, mit Sensoren, die der Position der Signalgeber entsprechende Signale generieren.

Geradsymmetrische Signale werden benötigt z. B. zur Ermittlung des Drehmoments und von Verdrehungen bei umlaufenden Wellen. Dabei werden im allgemeinen auf der Welle bereits vorhandene oder speziell für diesen Zweck angebrachte Zahnräder, markierte Räder, Ringe od. dgl. als Signalgeber verwendet. Zur Generierung von Signalen werden z. B. magnetische Sensoren wie Hallelemente, Feldplattenfühler oder vorzugsweise Differentialanordnungen, eingesetzt, bei denen die Differenz des äußeren magnetischen Widerstands an den Polen des Sensors das Sensorsignal bestimmt. Ein bestimmter Sensor ist dabei nur für eine bestimmte Geometrie des Signalgebers mit einer bestimmten periodischen Struktur brauchbar. Eine Abweichung der periodischen Struktur, z. B. bei Zahnrädern die Zahnteilung, führt zu schiefsymmetrischen Signalen, die das Meßergebnis verfälschen.

Aus der DE-OS 32 35 122 ist ein Drehmoment-Meßgerät bekannt, nach dem die Verlagerungen der Welle dadurch kompensiert werden, daß vier Sensoren in einer horizontalen Ebene an gegenüberliegenden Seiten der mit Mustern versehenen Welle angeordnet sind. Dabei ist jedoch eine gleichzeitige Symmetrierung der Signale nicht möglich.

Der vorliegenden Erfindung liegt die Aufgabe zugrunde, eine Anordnung zu schaffen, mit der schiefsymmetrische Sensorsignale ausgeschlossen werden können. Diese Anordnung soll dadurch ermöglichen, beliebige in einer Maschine, z. B. Getriebe, vorhandene Räder, Scheiben od. dgl. als Geber zu benutzen, ohne daß für jeden solchen Geber ein eigener, angepaßter Sensor vorgesehen werden muß, um geradsymmetrische Signale zu erhalten.

Diese Aufgabe ist erfindungsgemäß dadurch gelöst, daß für mindestens einen Signalgeber mindestens zwei Sensoren vorgesehen sind, deren Signale in eine Subtrahier- oder Addierstufe miteinander verknüpfbar sind, und daß die Sensoren mindestens eine halbe Periode der Struktur des Signalgebers zueinander versetzt angeordnet sind. In den Unteransprüchen sind vorteilhafte Ausführungsformen der Erfindung beschrieben.

Die beiden Sensoren für den einen Geber werden vorzugsweise eine halbe Periode plus eine oder mehrere ganze Perioden der Struktur des Gebers zueinander versetzt angeordnet. Gemäß einer besonders bevorzugten Ausführungsform der Erfindung werden die Sensoren derart versetzt zueinander positioniert, daß sie sich in bezug auf den Signalgeber an zwei möglichst gegenüberstehenden Stellen befinden.

Die erfindungsgemäße Anordnung ermöglicht die Kompensation der Verlagerungen der Welle unter gleichzeitiger Symmetrierung des Ausgangssignals. Da beide Sensoren jeweils einem Geber zugeordnet werden, ist eine beliebige räumliche Anordnung der beiden Sensoren gegenüber den Sensoren der anderen Geber denkbar. Falls nicht notwendig, kann bei einem Geber auf die Kompensation verzichtet werden; somit werden nur drei Sensoren benötigt. Die Anordnung erfordert zudem einen geringen elektronischen Aufwand.

Die Erfindung ist anhand der folgenden Beschreibung sowie schematischen Zeichnung näher erläutert. Es zeigen:

Fig. 1 die erfindungsgemäße Anordnung bei Verwendung eines Zahnrades als Geber;

Fig. 2 Zeitverläufe der Sensorsignale bei der Anordnung gemäß Fig. 1;

Fig. 3 eine besonders bevorzugte Ausführungsform der erfindungsgemäßen Anordnung und

Fig. 4 Zeitverläufe der Sensorsignale bei der Anordnung gemäß Fig. 3.

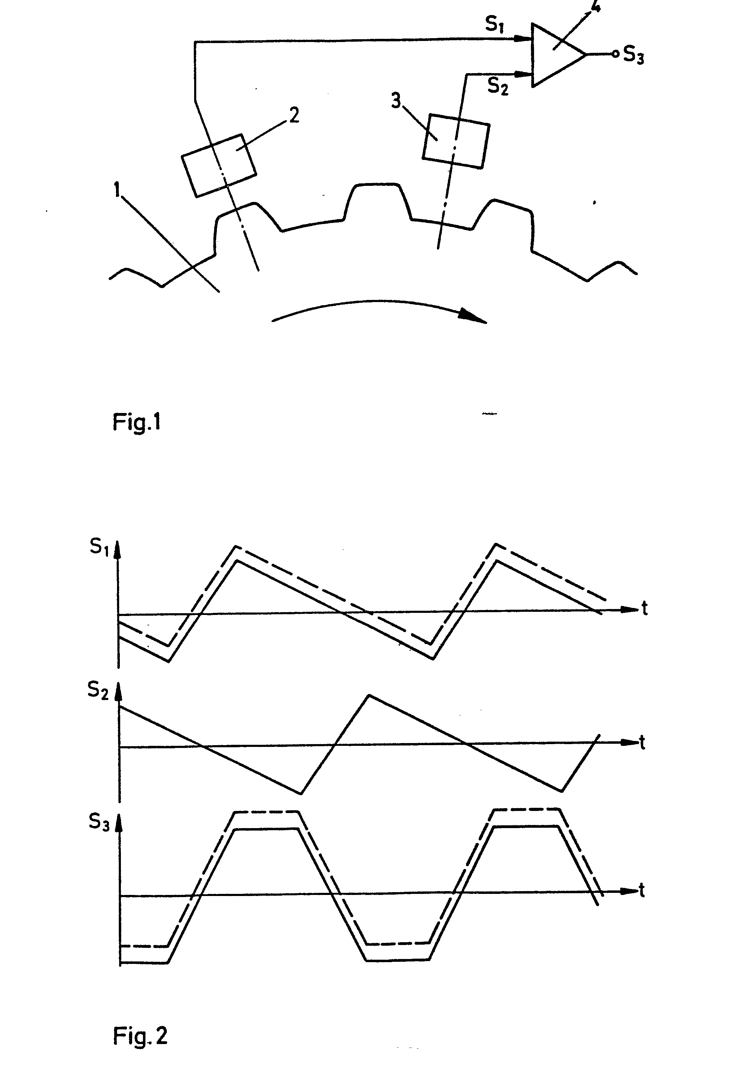

Bei der in Fig. 1 dargestellten Anordnung, wird durch zwei an einem Geberrad 1, hier ein Zahnrad, angeordneten Sensoren 2 und 3 durch Kombination der Signale aus ursprünglich schiefsymmetrischen Signalen ein geradsymmetrisches Signal gewonnen. Die beiden Sensoren 2 und 3 werden dabei um mindestens eine halbe Periode der Zahnteilung versetzt zueinander positioniert. Im dargestellten Fall beträgt die Distanz eine halbe Zahnteilung plus eine ganze Zahnteilung.

Damit ergeben sich Zeitläufe der Sensorsignale nach Fig. 2 a) und b). Durch Substraktion der beiden Sensorsignale voneinander, z. B. in einem Differenzverstärker, ergibt sich das erwünschte geradsymmetrische Gesamtsignal gemäß Fig. 2 c).

Ist gegenüber Fig. 2 a) und b) eines der Signale in seiner Phase um eine halbe Periode verschoben, so sind die beiden Signale zu addieren, um das geradsymmetrische Gesamtsignal zu erhalten. Eine Änderung des Gleichspannungsanteils der

Signale verändert nicht den geradsymmetrischen Verlauf, wie dies in unterbrochenen Linien in Fig. 2 gezeigt ist.

Vom Prinzip her ist die erfindungsgemäße Anordnung für alle Sensoren geeignet, die ein schiefsymmetrisches Ausgangssignal haben.

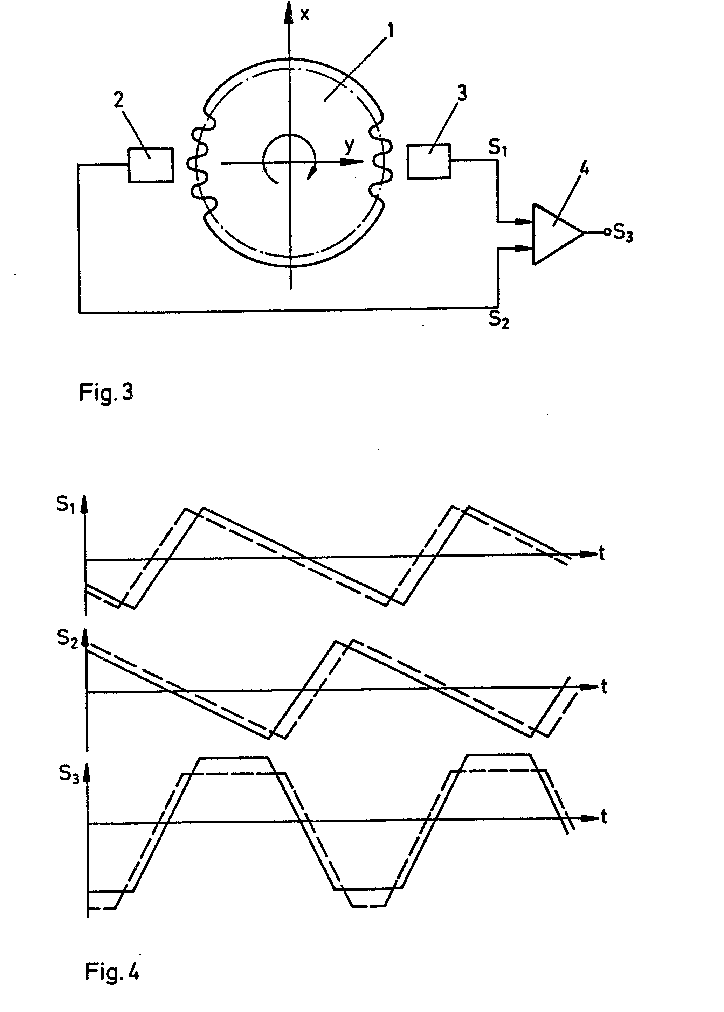

In Fig. 3 wird eine besonders vorteilhafte Ausführungsform der erfindungsgemäßen Anordnung gezeigt. Hier sind die Sensoren 2 und 3 so um ein ungerades Vielfaches der Zahnteilung versetzt, daß sie sich am Geberrad 1 gerade gegenüberstehen. Dies ist im Idealfall nur bei einer ungeraden Zähnezahl des Geberrades 1 möglich, praktisch aber auch bei großer gerader Zähnezahl gegeben. Verlagerungen der Welle infolge Lagerspiel in Y-Richtung, wie in Fig. 4 gezeigt, führen nicht zu einer Phasenverschiebung der Signale der Sensoren 2 und 3 zueinander. Es ändern sich die Amplituden, jedoch bleibt der Nulldurchgang des Gesamtsignals erhalten. Eine Verlagerung in X-Richtung führt beim Sensor 2 zu einer bestimmten negativen, beim Sensor 3 zu einer gleichgroßen positiven Phasenverschiebung, wie in Fig. 4 mit unterbrochenen Linien dargestellt ist. Auf die Mittellage des Gesamtsignals bleibt dies ohne Einfluß. Bei nur einem Sensor würde hierdurch ein Meßfehler entstehen. In gleicher Weise wird der Einfluß eines über den Umfang des Geberrades 1 sinusförmig verteilten Teilungsfehlers bzw. mit ungeraden Vielfachen der Periode auf den Meßwert eliminiert. In Fig. 3 ist außerdem dargestellt, daß die Ausgänge der Sensoren 2 und 3 zu einem Differenz- oder Summenverstärker 4 geführt werden, an dessen Ausgang das Gesamtsignal erhalten wird.

- . -

**0249026**

394-91/CASCH/BES                    28. April 1986


BATTELLE-INSTITUT E.V., Frankfurt am Main


========================================================
Anordnung zur Gewinnung von geradsymmetrischen Signalen
========================================================


Patentansprüche


1. Anordnung zur Gewinnung von geradsymmetrischen Signalen aus mindestens zwei Signalgebern mit periodischer Struktur, die relativ zueinander beweglich sind, mit Sensoren, die der Position der Signalgeber entsprechende Signale generieren, dadurch gekennzeichnet, daß für mindestens einen Signalgeber (1) mindestens zwei Sensoren (2,3) vorgesehen sind, deren Signale in einer Subtrahier- oder Addierstufe (4) miteinander verknüpfbar sind, und daß die Sensoren (2,3) mindestens eine halbe Periode der Struktur des Signalgebers (1) versetzt zueinander angeordnet sind.


2. Anordnung nach Anspruch 1, dadurch gekennzeichnet, daß die beiden Sensoren (2,3) eine halbe Periode plus eine oder mehrere ganze Perioden der Struktur des Signalgebers (1) versetzt zueinander angeordnet sind.


3. Anordnung nach Anspruch 1 oder 2, dadurch gekennzeichnet, daß als Signalgeber (1) Zahnräder oder Räder mit periodischen optischen Markierungen vorgesehen sind.

4. Anordnung nach einem der Ansprüche 1 bis 3, <u>dadurch</u> <u>gekennzeichnet</u>, daß die beiden Sensoren (2,3) derart versetzt zueinander angeordnet sind, daß sie sich in bezug auf den Signalgeber an zwei möglichst gegenüberliegenden Stellen befinden.

— . —

Fig.1

Fig.2

Fig. 3

Fig. 4